Europäisches Patentamt

European Patent Office

Office européen des brevets

(11) Publication number: **0 067 419**
**B1**

# EUROPEAN PATENT SPECIFICATION

(45) Date of publication of patent specification: **30.08.89**

(21) Application number: **82105074.7**

(22) Date of filing: **09.06.82**

(51) Int. Cl.⁴: **H 01 L 21/76, H 01 L 21/265, H 01 L 29/06**

(54) **Method of manufacturing integrated circuit devices using dielectric isolation.**

(30) Priority: **10.06.81 JP 88257/81**
**14.09.81 JP 143798/81**
**14.09.81 JP 143799/81**
**30.09.81 JP 155170/81**

(43) Date of publication of application:
**22.12.82 Bulletin 82/51**

(45) Publication of the grant of the patent:
**30.08.89 Bulletin 89/35**

(84) Designated Contracting States:
**DE FR GB NL**

(56) References cited:
**EP-A-0 025 129**
**EP-A-0 055 521**
**EP-A-0 062 722**
**US-A-3 899 363**
**US-A-4 144 101**
**US-A-4 178 191**
**US-A-4 198 649**

(73) Proprietor: **KABUSHIKI KAISHA TOSHIBA**
**72, Horikawa-cho Saiwai-ku**
**Kawasaki-shi Kanagawa-ken 210 (JP)**

(72) Inventor: **Kurosawa, Kei**
**1-17-10, Higashigaoka**
**Meguro-ku Tokyo (JP)**
Inventor: **Shibata, Tadashi**
**987-2-345, Kawawa-cho Midori-ku**
**Yokohama-shi Kanagawa-ken (JP)**

(74) Representative: **Blumbach Weser Bergen**
**Kramer Zwirner Hoffmann Patentanwälte**
**Radeckestrasse 43**
**D-8000 München 60 (DE)**

Courier Press, Leamington Spa, England.

# Description

This invention relates to a method for manufacturing integrated circuit devices according to the preamble of claim 1.

In an integrated semiconductor circuit device a thick oxide layer is usually provided on what is called a "field area" between semiconductor element regions, for the purpose of preventing inferior insulation caused by parasitic channels and increase of a parasitic capacity.

As a method of insulating elements using such an oxidation layer, the BOX (Buryling Oxide into silicon groove) method is well-known. This BOX method includes the following steps as disclosed in the Japanese patent application publication (No. 54—36034/1979).

First a resist mask for etching and ion-implantation is provided on a predetermined region, which will later form the semiconductor element region of a semiconductor substrate.

Next, by etching a field area of the substrate to a certain depth a groove surrounding the predetermined region is formed. Impurities of the same conductivity type as that of the substrate are introduced into the groove by an ion-implantation technique for preventing a conductivity type reversion.

After this, an oxidation layer is buried in the groove by a conventional lift-off method. Furthermore, semiconductor elements, e.g. insulated gate type field effect transistors, are formed on the predetermined region of the semiconductor substrate. Then metal interconnections are provided between the semiconductor elements.

According to this BOX method, the size of the resultant semiconductor element region is defined by the said resist mask. Therefore integrated circuit devices made by the BOX method possess few dimension errors and feature high integration density. Furthermore the BOX method contributes to high lithography accuracy at the wiring process and high reliability, because the surface of the substrate remains flat.

According to this BOX method, the impurities for preventing conductivity type reversion are implanted into the bottom part of the groove formed in the semiconductor substrate, however hardly into the side wall part thereof. It is therefore impossible to accomplish sufficient elements insulation in the fabricated integrated circuit because a parasitic channel is often formed in the side wall part of the groove.

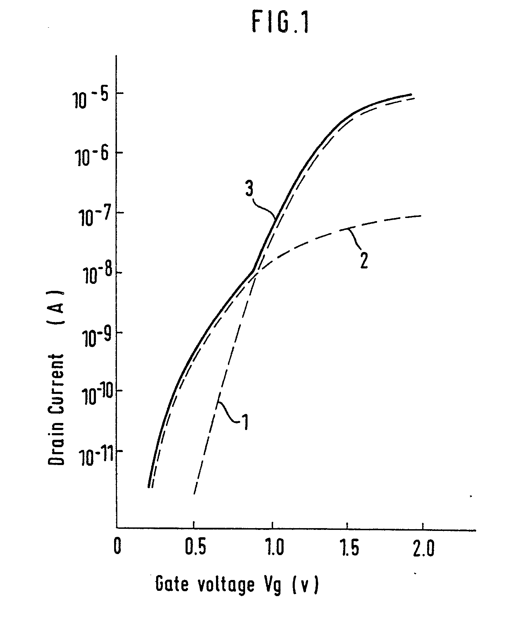

Fig. 1 shows the relation between gate voltage Vg and drain current Id, that is to say, a sub-threshold characteristic if insulated gate type field effect transistors are provided as semiconductor elements. Curve 3 shows a sub-threshold characteristic comprising an essential desirable charateristic curve 1 and an additional characteristic curve 2 of a parasitic transistor. Such a characteristic causes a leakage current at off-state of the transistors and is likely to invite error action or elements failure of the integrated circuit.

US—A—3899363 discloses a method similar to the above explained BOX method which allows, however, ions to be implanted into the side wall part of the groove. This is achieved by a specific technique forming slanted side walls of the groove and of the ion implantation mask layers. The lower part of the slanted side wall of the groove is directly exposed to the ions during the ion implantation step. The upper part of the side wall at the surface region of the substrate is exposed to the ion beam through the slanted etches of the implantation mask layers. Several disadvantages are involved in this prior art as explained in US—A—4 144 101. The latter document discloses a different method where the whole substrate surface is covered with the field insulation layer, ions then being implanted through the field insulation layer into the field area of the substrate. After the implantation step the field insulation material is removed from the element regions between the field areas resulting in a structure where the surface of the field insulation layer is higher than the substrate surface in the element regions forming undesirable steps.

Accordingly an object of the invention is to provide a method for manufacturing integrated circuit devices which have a very small dimension error of the element region and a high lithography accuracy at the wiring process, and simultaneously prevents generation of parasitic channels effectively by introducing impurities for preventing conductivity type reversion with high controllability.

This object has been attained by the method as claimed in claim 1.

This invention applies not only to integrated circuits including insulated gate type field effect transistors, but also to those including bipolar transistors or complementary insulated gate type field effect transistors (CMOS).

With the invention it is possible to use a semiconductor wafer or a SOS structure wherein a semiconductor layer for making elements is provided on an insulation substrate. It is also possible to use a SOI structure wherein a semiconductor layer for making elements is provided on an insulation film on a subtrate.

In a first ion-implantation step, impurities of the same conductivity type as that of the substrate are implanted in the form of ions before forming a groove for burying insulation material, in order that part of the impurities will be present in the side wall part of the subsequently formed groove. Therefore, it is possible to effectively prevent conductivity type reversion in the side wall part of the groove where the problem of parasitic channel generation arises especially.

In the invention, for the purpose of increasing process accuracy, the same mask pattern which was used for said first ion-implantation should also be used as a mask for a second ion-implantation which is carried out after the groove has been formed. Furthermore, for the same purpose it is desirable that the grooving be carried out by a reactive ion-etching method, and the burying of insulation material in the groove by a lift-off method.

It is preferable that during the first implantation step the penetration depth and the dose value are changed to have an impurity concentration decreasing from the surface toward the inside of the substrate. This prevents a breakdown voltage fall of the diffusion layers consistuting the semiconductor elements and an operating speed fall of the semiconductor elements due to an increase of the junction capacity between the diffusion layers and the substrate.

It is possible to prevent the parasitic channel generation even more effectively by placing the peak value of the impurity distribution resulting from the first implantation at the surface region of the semiconductor substrate. This may be accomplished by using a relatively low acceleration voltage or by providing a film on the field area in advance.

In addition, it is possible to prevent parasitic channel generation more effectively by thermally diffusing the impurities implanted into the semiconductor substrate by the first implantation, so that a higher amount of impurities penetrates into the region below the implantation mask pattern and that sufficient impurities will remain at the side wall part of the groove formed subsequently.

When insulated gate type field effect transistors are provided as the semiconductor elements, according to an embodiment of the invention, the impurity distribution is projected far into a region below the predetermined element region by the second ion-implantation. Consequently, it is possible to prevent invasion of a current produced by impact ionization beside the drain regions of the transistors upon the other regions of the semiconductor substrate. Therefore, when dynamic random access memories are provided as the semiconductor elements in the invention, error action thereof is prevented.

Ways of carrying out the invention are described in detail below with reference to drawings, which illustrate only specific embodiments, in which:

Fig. 1 shows a sub-threshold characteristic due to a parasitic channel generation;

Figs. 2 to 10 are cross-sectional views of a semiconductor substrate at respective steps of one embodiment of the invention;

Figs. 11 to 13 are cross-sectional views of a semiconductor substrate at respective improved steps of ion-implantation into a semiconductor substrate.

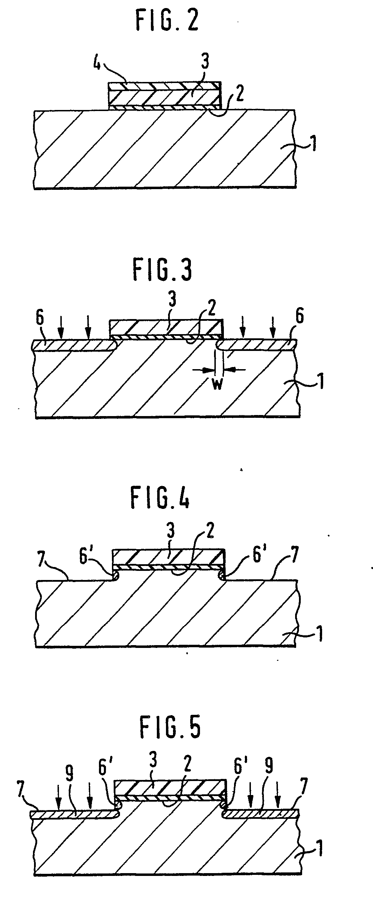

A first embodiment of the invention will be described in detail with reference to Figs. 2 to 10.

In Fig. 2, a P-type silicon substrate 1 of a 5—50 $\Omega \cdot cm$ specific resistivity with a <100> crystal surface orientation is prepared first. It is also possible to use gallium arsenic as the substrate material.

Next a thermal oxidation film 2 with a thickness of about 50 nm is formed on substrate 1, and furthermore a silicon-nitride layer 3 with a thickness of about 0.5 μm and a resist film 4. Silicon-nitride layer 3 is used as a mask for ion-implantation and etching at subsequent manufacturing steps. Instead of silicon-nitride layer 3, an aluminum layer, a poly-silicon layer or a phosphorus-doped silicon oxide layer can be used.

After this, resist film 4 is patterned in accordance with the size of a predetermined element region by a conventional photo-etching method. Silicon-nitride layer 3 and thermal oxidation film 2 are subsequently etched off using the patterned resist film 4 as a mask (Fig. 2).

After removing the patterned resist film 4 boron ions are implanted into semiconductor substrate 1 using silicon-nitride layer 3 as a mask, so that a P-type region 6 of an impurity concentration higher than that of substrate 1 is formed (Fig. 3). It may be advantageous but is not absolutely necessary to remove the patterned resist film 4 before the ion-implantation. The above first ion-implantation is carried out, for example, under a 140 keV acceleration voltage and a $1 \times 10^{13}$ cm$^{-2}$ dose value. In this case, the projected range reaches 0.45 μm, the standard deviation 0.11 μm, and the lateral invasion range W of P-type region 6 into the predetermined element region, 0.14 μm.

After the ion-implantation, substrate 1 is preferably exposed to a 1000°C temperature for 30 minutes in a nitrogen gas atmosphere. This heat treatment makes the lateral invasion range W expand to 0.3 μm which effectively contributes to preventing conductivity type reversion.

Next semiconductor substrate 1 is partly etched from its surface to a depth of 0.4—0.8 μm by anisotropic etching method using silicon nitride layer 3 as an etching mask. Considering etching accuracy, reactive ion-etching is desirably used as the anisotropic etching. A P-type region 6' remains in a side wall part of the groove 7 formed by the above etching process (Fig. 4).

If relatively light ions with a large scattering angle, for example boron as in this case, are implanted into the semiconductor substrate, there occurs a wide range ion distribution in the lateral direction under silicon nitride layer 3, i.e. the ion-implantation mask. After the ion-implantation, the impurity concentration distribution shows a Gaussian distribution with a projected range Rp and a standard deviation ΔRp in the depth direction. The impurity concentration distribution shows a Gaussian distribution also in the lateral direction, so that it is possible to implant an adequate dosage of boron with high controllability into the side wall part of groove 7.

Therefore, the invention effectively prevents: the narrow channel effect with respect to insulated gate type field effect transistors, which occurs in case of too much boron implantation and lateral diffusion of impurities at subsequent heating steps; a breakdown voltage fall of diffusion layers being formed on the predetermined element region; and an operation speed fall, which is caused by increase of a junction capacity between the diffusion layers and the substrate.

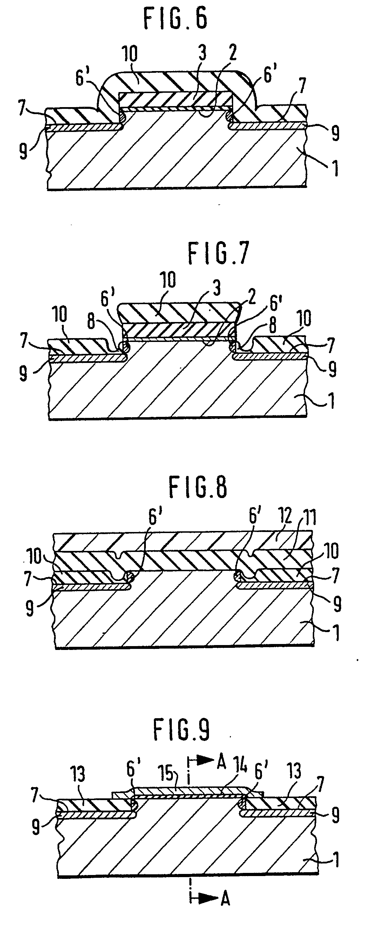

Next boron ions are implanted into groove 7 with a 20—50 keV acceleration voltage and a $1 \times 10^{12}$ cm$^{-2}$ dose value (the second ion-implantation), so that a P-type region 9 is formed at the bottom part of groove 7. Then a silicon dioxide film 10 of a 0.6 to 1.5 μm thickness is formed all over the surface of substrate 1 by chemical vapor deposition in plasma (Fig. 6).

A different method of forming the silicon dioxide film, for example spattering, evaporation or thermal oxidation, can be applied at this step. The silicon dioxide film may contain phosphorus, arsenic or boron. Furthermore it is possible to use fluid glass instead of silicon dioxide.

Subsequently silicon dioxide film 10 is etched by a buffered hydrofluoric acid solution for 1 minute, and is selectively removed off at the stair-like portion, as shown in Fig. 7. This is because the plasma-CVD silicon dioxide film deposited on the stair-like portion between the predetermined element region and the field area has an etching speed 3—20 times higher than that of the other flat portions. After this, semiconductor substrate 1 is exposed under the atmosphere of wet or dry oxygen to a temperature of 1000°C for 20 minutes. Consequently a thin oxidation film 8 is formed at the periphery of the predetermined element region, which contributes to reliable electrical insulation of the region. However, this step is not absolutely necessary. Furthermore an ammonium fluoride may be used for etching silicon dioxide film 10 instead of said hydrofluoric acid solution.

In a next step the silicon nitride layer 3 and the oxidation film 2 are moved using etching solutions. Then a silicon dioxide film 11 is deposited on silicon dioxide film 10 by chemical vapor deposition. Thereon a melted resist is coated and solidified, so that a resist film 12 is formed and the surface is flattened (Fig. 8). In this step, it is possible to use a thermal oxidation film or a meltable glass such as phosphorsilicate glass or phosphor-boronsilicate glass instead of silicon dioxide film 11 and resist film 12.

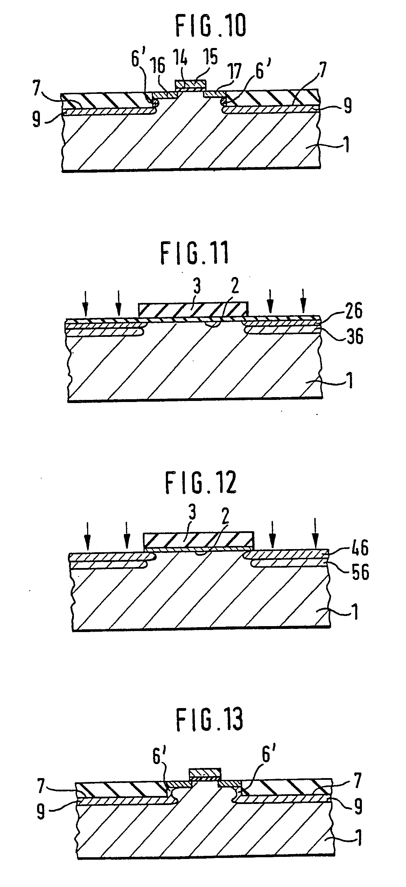

Next resist film 12 and silicon dioxide film 11 are etched till the predetermined element region is exposed, so that a flat field oxide film 13 is formed without leaving any stair-like portion (Fig. 9). A gate oxide film 14 is then formed on the exposed predetermined element region of semiconductor substrate 1 by thermal oxidation, and further thereon a poly-silicon film is formed. By patterning the poly-silicon film by a lithography technique, a gate electrode 15 is formed and gate oxide film 14 is partly etched off. Arsenic ions are then implanted into semiconductor substrate 1 using gate electrode 15 as an implantation mask. As shown in Fig. 10, which is a cross-sectional view taken along line A—A given in Fig. 9, a source region 16 and a drain region 17 are formed by this implantation, and an insulated gate type field effect transistor is completed. Additionally, metal interconnections (not shown in Figures) are provided on substrate 1 and an integrated circuit is made.

Fig. 11 shows a modification of the above first ion implantation step. Compared to the implantation step explained in connection with Fig. 3 the ions are implanted through the oxidation film 2 existing in the field area on the substrate surface. In this embodiment, a P-type region 26 is formed by an ion implantation with a 130 keV acceleration voltage and a $1 \times 10^{13}$ cm$^{-2}$ dose value, and additionally a P-type region 36 is formed by another ion implantation with a 150 keV acceleration voltage and a $3 \times 10^{13}$ cm$^{-2}$ dose value. Because of the existence of oxidation film 2, the impurity concentration distribution produced by the former ion-implantation shows a maximum value at the surface region of substrate 1. By the latter ion implantation, a small dosage of impurities is introduced into the deep region of substrate 1. Accordingly, conductivity type reversion in the surface region, where a parasitic channel tends to be formed, is effectively prevented. Furthermore, breakdown voltage fall of the diffusion layers constituting the transistor and increase of the junction capacity are prevented.

Fig. 12 shows a further modified example of carrying out the above first ion implantation step (Fig. 3). In this embodiment, a P-type region 46 is formed by ion implantation with a 50 keV acceleration voltage and a $1 \times 10^{13}$ cm$^{-2}$ dose value and a P-type region 56 by another ion implantation with a 180 keV acceleration voltage and a $2 \times 10^{12}$ dose value. According to this embodiment, an effect similar to that of the embodiment in Fig. 11 can be expected. As shown in Fig. 12 the field area is not covered by oxidation film 2 during the ion implantation in this case.

Fig. 13 shows a modified embodiment of the second ion implantation step (Fig. 5) in conjunction with a first implantation according to Fig. 12, wherein the second implantation is carried out with a 250 keV acceleration voltage and a $1 \times 10^{14}$ cm$^{-2}$ dose value so that the ion implantation impurity distribution will project far into the region under the predetermined element region. According to this embodiment, if insulated gate type effect transistors are used as the elements in the invention, it will be possible to prevent invasion of a current produced by impact ionization beside the drain regions of the transistors upon the other regions of semiconductor substrate 1.

**Claims**

1. A method for manufacturing integrated circuit devices wherein semiconductor elements are insulated by insulation material comprising the following steps of:

a) providing a mask pattern (3) on a predetermined element region of a semiconductor substrate (1);

b) etching the substrate (1) and forming a groove (7) therein using the mask pattern (3) as an etching mask;

c) introducing impurities of the same conductivity type as that of the substrate (1) through the groove (7) into the substrate (1) by ion-implantation;

d) burying insulation material (10) in the groove (7);

e) forming semiconductor elements on the predetermined element region;
characterized in that the method further includes the step of:

f) after step a) and before step b), introducing impurities of the same conductivity type as that of the substrate (1) into the substrate (1) using the mask pattern (3) as an ion-implantation mask in a manner that part of the impurities is introduced at least at the surface region of the substrate (1) under the mask pattern (3) to remain in the side wall of the groove (7).

2. The method for manufacturing integrated circuit devices according to claim 1, wherein the mask pattern (3) is also used as mask in step c).

3. The method for manufacturing integrated circuit devices according to claim 1 or 2, wherein the groove (7) is formed by reactive ion etching.

4. The method for manufacturing integrated circuit devices according to claim 1, 2 or 3, wherein the method for burying insulation material in the groove comprises the following steps of:

l) forming a silicon oxide layer (10) on the semiconductor substrate having the groove (7) by chemical vapor deposition in plasma;

m) etching off the silicon oxide layer (10) at the periphery of the mask pattern (3);

n) removing the mask pattern (3);

o) providing a new silicon oxide layer (11) on the silicon oxide layer (10), furthermore providing thereon a melted film (12) and solidifying it;

p) etching the solidified film (12) and the new silicon oxide layer (11) in order to leave a flat silicon oxide layer (13) in the groove (7).

5. The method for manufacturing integrated circuit devices according to any of claims 1 to 4, wherein the semiconductor elements are insulated gate type field effect transistors.

6. The method for manufacturing integrated circuit devices according to any of claims 1 to 5, wherein the impurity dose value and the acceleration voltage are changed during the first ion implantation in order to have the impurity concentration decreasing with the depth from the substrate surface to the inside.

7. The method for manufacturing integrated circuit devices according to any of claims 1 to 6, wherein the first ion implantation is carried out under the condition that a film (2) exists all over the surface of the substrate (1).

8. The method for manufacturing integrated circuit devices according to any of claims 1 to 7, wherein the method further includes the step of diffusing the impurities introduced into the substrate (1) after step (b) before step (c).

9. The method for manufacturing integrated circuit devices according to any of claims 1 to 8, wherein the impurity distribution is projected into the region under the predetermined element region by the second ion implantation.

## Patentansprüche

1. Verfahren zur Herstellung integrierter Schaltungen, bei denen Halbleiterelemente durch Isoliermaterial isoliert sind, umfassend die folgenden Schritte:

a) Ausbilden eines Maskenmusters (3) auf einem vorbestimmten Elementenbereich eines Halbleitersubstrats (1),

b) Ätzen des Substrats (1) und Ausbilden einer Nut (7) in dem Substrat unter Verwendung des Maskenmusters (3) als Ätzmaske,

c) Einführen von Störstellen desselben Leitungstyps, wie sie das Substrat (1) aufweist, durch die Nut (7) in das Substrat (1) durch Ionenimplantation,

d) Vergraben von Isoliermaterial (10) in der Nut (7),

e) Ausbilden von Halbleiterelementen in dem vorbestimmten Elementenbereich
dadurch gekennzeichnet, daß das Verfahren den weiteren Schritt aufweist:

f) daß nach Schritt a) und vor Schritt b) Störstellen desselben Leitungstyps, wie sie das Substrat (1) aufweist,
unter Verwendung des Maskenmusters (3) als einer Ionenimplantationsmaske so in das Substrat (1) eingeführt werden, daß ein Teil der Störstellen wenigstens in den Oberflächenbereich des Substrats (1) unter dem Maskenmuster (3) eingeführt wird, um in der Seitenwand der Nut (7) zu bleiben.

2. Verfahren zur Herstellung integrierter Schaltungen nach Anspruch 1, bei dem das Maskenmuster (3) auch als Maske in Schritt (c) verwendet wird.

3. Verfahren zur Herstellung integrierter Schaltungen nach Anspruch 1 oder 2, bei dem die Nut (7) durch reaktives Ionenätzen ausgebildet wird.

4. Verfahren zur Herstellung integrierter Schaltungen nach Anspruch 1, 2 oder 3, bei dem das Verfahren zum Vergraben des Isoliermaterials in der Nut folgende Schritte umfaßt:

l) Ausbilden einer Siliciumoxidschicht (10) auf dem mit der Nut (7) versehenen Halbleitersubstrat durch chemische Dampfabscheidung in Plasma,

m) Abätzen der Siliciumoxidschicht (10) am Rand des Maskenmusters (3),

n) Entfernen des Maskenmusters (3),

o) Ausbilden einer neuen Siliciumoxidschicht (11) auf der Siliciumoxidschicht (10) und weiterhin Ausbilden eines geschmolzenen Films (12) darauf und Verfestigen desselben,

p) Ätzen des verfestigten Films (12) und der neuen Siliciumoxidschicht (11), damit eine flache Siliciumoxidschicht (13) in der Nut (7) zurückbleibt.

5. Verfahren zur Herstellung integrierter Schaltungen nach einem der Ansprüche 1 bis 4, bei dem die Halbleiterelemente Feldeffekttransistoren mit isoliertem Gate sind.

6. Verfahren zur Herstellung integrierter Schaltungen nach einem der Ansprüche 1 bis 5, bei dem der Störstellendosiswert und die Beschleuni-

gungsspannung während der ersten Ionen-implantation geändert werden, damit die Störstellenkonzentration mit der Tiefe von der Substratoberfläche zur Innenseite hin abnimmt.

7. Verfahren zur Herstellung integrierter Schaltungen nach einem der Ansprüche 1 bis 6, bei dem die erste Ionenimplantation unter dem Zustand ausgeführt wird, daß ein Film (2) auf der gesamten Oberfläche des Substrats (1) vorhanden ist.

8. Verfahren zur Herstellung integrierter Schaltungen nach einem der Ansprüche 1 bis 7, das den weiteren Schritt des Diffundierens der in das Substrat (1) eingeführten Störstellen nach Schritt (b) und vor Schritt (c) enthält.

9. Verfahren zur Herstellung integrierten Schaltungen nach einem der Ansprüche 1 bis 8, bei dem die Störstellenverteilung durch die zweite Ionenimplantation in den Bereich unter dem vorbestimmten Elementenbereich ausgedehnt wird.

## Revendications

1. Procédé de fabrication de dispositifs à circuit intégré, où des éléments semiconducteurs sont isolés à l'aide de matériau d'isolation, comprenant les opérations suivantes:

a) produire une configuration de masquàge (3) sur une région d'élément prédéterminée d'un substrat semiconducteur (1);

b) graver le substrat (1) et former une rainure (7) dans celui-ci en utilisant la configuration de masquage (3) comme masque de gravure;

c) introduire des impuretés du même type de conductivité que celui du substrat (1) via la rainure (7) dans le substrat (1) par implantation ionique;

d) enterrer un matériau d'isolation (10) dans la rainure (7);

e) former des éléments semiconducteurs sur la région d'éléments prédéterminée;
caractérisé en ce que le procédé comprend en outre l'opération suivante:

f) après l'opération a) et avant l'opération b), introduire des impuretés du même type de conductivité que celui du substrat (1) dans le substrat (1) en utilisant la configuration de masquage (3) comme masque d'implantation ionique de manière qu'une partie des impuretés soit introduite au moins au niveau de la région de surface du substrat (1) sous la configuration de masquage (3) afin de rester dans la paroi latérale de la rainure (7).

2. Procédé de fabrication de dispositifs à circuit intégré selon la revendication 1, où on utilise également la configuration de masquage (3) comme masque dans l'opération c).

3. Procédé de fabrication de dispositifs à circuit intégré selon la revendication 1 ou 2, où on forme la rainure (7) par gravure à l'aide d'ions réactifs.

4. Procédé de fabrication de dispositifs à circuit intégré selon la revendication 1, 2 ou 3, où le procédé permettant d'enterrer un matériau d'isolation dans la rainure comprend les opérations suivantes:

l) former une couche d'oxyde de silicium (10) sur le substrat semiconducteur possédant la rainure (7) par dépôt chimique sous forme vapeur dans du plasma;

m) enlever par gravure la couche d'oxyde de silicium (10) au niveau de la périphérie de la configuration de masquage (3);

n) retirer la configuration de masquage (3);

o) produire une nouvelle couche d'oxyde de silicium (11) sur la couche d'oxyde de silicium (10), produire en outre sur celle-ci une pellicule fondue (12) et la faire solidifier;

p) graver la pellicule solidifiée (12) et la nouvelle pellicule d'oxyde de silicium (11) de manière à laisser une couche d'oxyde de silicium (13) plane dans la rainure (7).

5. Procédé de fabrication de dispositifs à circuit intégré selon l'une quelconque des revendications 1 à 4, où les éléments semiconducteurs sont des transistors à effet de champ du type à grille isolée.

6. Procédé de fabrication de dispositifs à circuit intégré selon l'une quelconque des revendications 1 à 5, où on fait varier la valeur de la dose d'impureté et la tension d'accélération pendant la première implantation ionique afin de faire diminuer la concentration en impureté avec la profondeur, de la surface du substrat à l'intérieur.

7. Procédé de fabrication de dispositifs à circuit intégré selon l'une quelconque des revendications 1 à 6, où on effectue la première implantation ionique sous la condition où il existe une pellicule (2) sur toute la surface du substrat (1).

8. Procédé de fabrication de dispositifs à circuit intégre selon l'une quelconque des revendications 1 à 7, où le procédé comporte en outre l'opération consistant à faire diffuser les impuretés introduites dans le substrat (1) après l'opération (b) avant l'opération (c).

9. Procédé de fabrication de dispositifs à circuit intégré selon l'une quelconque des revendications' 1 à 8, où la distribution des impuretés est projetée dans la région se trouvant sous la région d'éléments prédéterminée par la deuxième implantation ionique.

FIG.1

## FIG. 2

## FIG. 3

## FIG. 4

## FIG. 5

# FIG. 6

# FIG. 7

# FIG. 8

# FIG. 9

FIG.10

FIG.11

FIG.12

FIG.13